# EUROPEAN PATENT APPLICATION

(11) **EP 2 015 380 A2**
(43) Date of publication of application: **14.01.2009**
(21) Application number: 08157596.1
(22) Date of filing: 04.06.2008
(51) Int. Cl.: H01L 51/52

(54) **Organic light emitting device and method of manufacturing the same**

(30) Priority: 05.06.2007 KR 20070055274
(71) Applicant: Samsung SDI Co., Ltd., Suwon-si, Gyeonggi-do (KR)
(72) Inventor: Han, Dong-Won, Gyeonggi-do (KR); Mo, Yeon-Gon, Gyeonggi-do (KR); Kwack, Jin-Ho, Gyeonggi-do (KR)
(74) Representative: Walaski, Jan Filip

(57) **Abstract**

An organic light emitting device includes an organic light emitting diode on a substrate and an encapsulation layer covering the organic light emitting diode. The encapsulation layer includes an organic layer, an inorganic layer on the organic layer, and an intermixing region between the organic layer and the inorganic layer, the organic layer includes an organic material, the inorganic layer includes an inorganic material, and the intermixing region includes the organic material and the inorganic material.

## Description

The present invention relates to an organic light emitting device and a method of manufacturing the same. More particularly, embodiments relate to an organic light emitting device including an encapsulation layer having an intermixing region.

Displays based on organic light emitting diodes (OLEDs) are self-emissive displays. OLED-based displays can be operated at a low voltage, can be extremely thin, can be viewed at wide angles, and can exhibit rapid response times. Therefore, they have received much attention as next-generation displays.

To improve reliability of organic light emitting devices, the OLEDs therein should be isolated from moisture and/or oxygen. Typically, a sealing container is used to isolate the OLEDs from moisture and/or oxygen, and a desiccant such as an alkali metal oxide is provided in the sealing container. However, due to the shape of the sealing container, a total thickness of the display device can be thick. In addition, the manufacturing process is complicated, and thus manufacturing costs may increase.

Embodiments are therefore directed to an organic light emitting device and a method of manufacturing the same, which substantially overcome one or more of the problems due to the limitations and disadvantages of the related art.

It is therefore a feature of an embodiment to provide an encapsulation layer having an intermixing region for preventing the ingress of moisture and/or oxygen.

It is therefore another feature of an embodiment to provide a method of forming an encapsulation layer that includes forming the intermixing region.

At least one of the above and other features and advantages may be realized by providing an organic light emitting device, including an organic light emitting diode on a substrate, and an encapsulation layer covering the organic light emitting diode.

The encapsulation layer may include an organic layer, an inorganic layer on the organic layer, and an intermixing region between the organic layer and the inorganic layer, the organic layer may include an organic material, the inorganic layer may include an inorganic material, and the intermixing region may include the organic material and the inorganic material.

The organic layer may be a polymeric layer. The inorganic material may include one or more of silicon nitride, aluminum nitride, zirconium nitride, titanium nitride, hafnium nitride, tantalum nitride, silicon oxide, aluminum oxide, titanium oxide, tin oxide, cerium oxide, or silicon oxide nitride.

The inorganic material may exhibit a concentration gradient at an interface with the intermixing region. The organic material may exhibit a concentration gradient at an interface with the intermixing region.

The intermixing region may have a thickness of about 1 nm to about 15 nm. The encapsulation layer may include the organic layer, the inorganic layer, and the intermixing region in a stack with a second organic layer, a second inorganic layer, and a second intermixing region, the second intermixing region being between the second organic layer and the second inorganic layer, the second organic layer may be on the inorganic layer, the intermixing region may have a thickness of about 1 nm to about 15 nm, and the second intermixing region may have a thickness of about 1 nm to about 15 nm.

At least one of the above and other features and advantages may also be realized by providing a method of manufacturing an organic light emitting device, including providing a substrate having an organic light emitting diode thereon, and forming an encapsulation layer covering the organic light emitting diode. Forming the encapsulation layer may include forming an organic layer, and using ion beam assisted deposition to simultaneously form an inorganic layer and an intermixing region, the intermixing region being between the organic layer and the inorganic layer. The organic layer may include an organic material, the inorganic layer may include an inorganic material, and the intermixing region may include the organic material and the inorganic material.

The ion beam assisted deposition may form the intermixing region by implanting particles of the inorganic material to a predetermined depth in the organic layer. The predetermined depth may be about 1 nm to about 15 nm. The organic layer may be formed of a polymeric layer. The inorganic material may include one or more of silicon nitride, aluminum nitride, zirconium nitride, titanium nitride, hafnium nitride, tantalum nitride, silicon oxide, aluminum oxide, titanium oxide, tin oxide, cerium oxide, or silicon oxide nitride.

The inorganic material may be deposited with a concentration gradient at an interface with the intermixing region. The organic material may be deposited with a concentration gradient at an interface with the intermixing region. The intermixing region may be formed to a thickness of about 1 nm to about 15 nm.

The ion beam assisted deposition may be performed with an ion beam source that releases ions of an inert atom, and the ion beam source may have an energy of about 50 eV to about 200 eV. Forming the encapsulation layer may further include forming a second organic layer on the inorganic layer, and using ion beam assisted deposition to simultaneously form a second inorganic layer and a second intermixing region, the second intermixing region being between the second organic layer and the second inorganic layer. The intermixing region may have a thickness of about 1 nm to about 15 nm, and the second intermixing region may have a thickness of about 1 nm to about 15 nm.

At least one of the above and other features and advantages may also be realized by providing a method of encapsulating a device, including providing a substrate having the device thereon, applying a first layer to cover the device, and after applying the first layer, implanting an inorganic material to a predetermined depth into an exposed surface of the first layer.

The above and other features and advantages will become more apparent to those of ordinary skill in the art by describing in detail exemplary embodiments with reference to the attached drawings, in which:
FIG. 1 illustrates a cross-sectional view of an organic light emitting device according to a first embodiment;
FIG. 2 illustrates a cross-sectional view of an organic light emitting device according to a second embodiment;
FIG. 3 illustrates a cross-sectional view of an organic light emitting device according to a third embodiment; and
FIGS. 4A and 4B illustrate schematic views of a method of manufacturing the organic light emitting device of FIG. 1.

Example embodiments will now be described more fully hereinafter with reference to the accompanying drawings; however, they may be embodied in different forms and should not be construed as limited to the embodiments set forth herein.

Rather, these embodiments are provided so that this disclosure will be thorough and complete, and will fully convey the scope of the invention to those skilled in the art.

In the figures, the dimensions of layers and regions may be exaggerated for clarity of illustration. Where an element is described as being coupled to a second element, the element may be directly coupled to second element, or may be indirectly coupled to second element via one or more other elements. Further, where an element is described as being coupled to a second element, it will be understood that the elements may be electrically coupled, e.g., in the case of transistors, capacitors, power supplies, nodes, etc. In the drawings, elements may be omitted for clarity. Like reference numerals refer to like elements throughout.

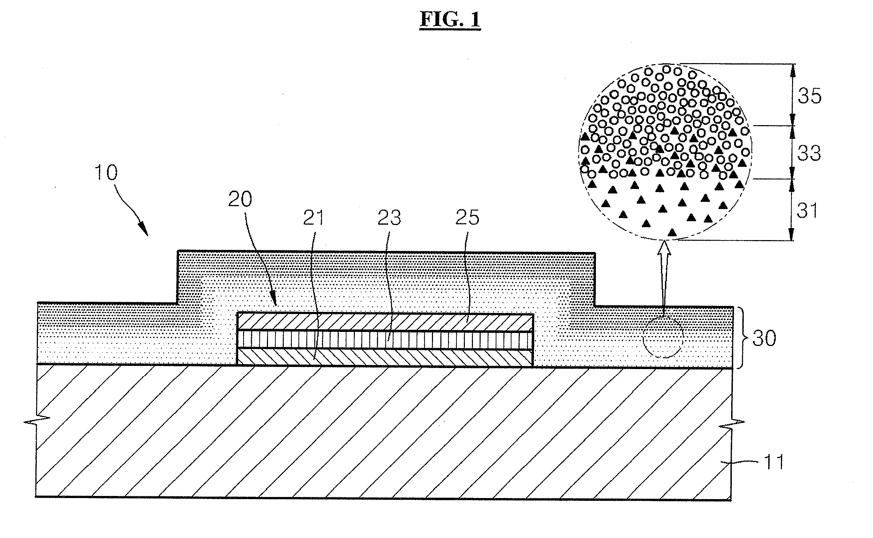

FIG. 1 illustrates a cross-sectional view of an organic light emitting device according to a first embodiment. Referring to FIG. 1, an organic light emitting device 10 may include a substrate 11, an OLED 20 that includes a first electrode 21, an emissive layer 23 and a second electrode 25, and an encapsulation layer 30 that covers the OLED 20. The encapsulation layer 30 may include an organic layer 31 and an inorganic layer 35. An intermixing region 33, which may include an organic material forming the organic layer 31 and an inorganic material forming the inorganic layer 35, may be provided at an interface of the organic layer 31 with the inorganic layer 35.

The substrate 11 may be any substrate suitable for use in organic light emitting devices, e.g., a glass substrate, a transparent plastic substrate, etc. The substrate 11 may have good mechanical strength, thermal stability, transparency, and surface smoothness, and may be easily processed and waterproof. The organic light emitting device may have various structures, e.g., a planarization film, an insulating layer, etc. (not shown), on the substrate 11.

The OLED 20 may include an emissive layer formed of an organic material between an anode and a cathode. In OLEDs, as a positive voltage and a negative voltage are respectively applied to the anode and cathode, holes injected from the anode may migrate into the emissive layer via a hole transport layer, and electrons injected from the cathode may migrate into the emissive layer via an electron transport layer. The electrons and holes may be recombined in the emissive layer to generate excitons. As the excitons change from an excited state to a ground state, fluorescent moieties of the emissive layer may emit light to form images on the display. The organic light emitting device 10 may have pixels that emit three colors, e.g., red (R), green (G) and blue (B), so as to realize a full color display.

The first electrode 21, which may be the cathode or the anode, may be formed using a technique such as vacuum deposition, sputtering or the like. The first electrode 21 may be a transparent electrode, a semi-transparent electrode, or a reflective electrode, and may be formed of ITO, IZO, Sn02, ZnO, Al, Ag, Mg, etc. Various modifications, such as a structure of at least two layers formed of at least two different materials, etc, may be implemented.

The second electrode 25, which may be the anode or the cathode, i.e., opposite to the first electrode 21, may be formed using a technique such as vacuum deposition, sputtering, etc. The second electrode may be formed of a low work-function metal, an alloy, an electrically conductive compound, a combination thereof, etc. In particular, the second electrode may be formed of Li, Mg, Al, Al-Li, Ca, Mg-In, Mg-Ag, etc. Various modifications, such as a structure of at least two layers formed of at least two different materials, etc., may be implemented.

The light emitting emissive layer 23 may be disposed between the first electrode 21 and the second electrode 25. The emissive layer 23 may include, e.g., hosts such as Alq3, 4,4'-N,N'-dicarbazol-biphenyl (CBP), poly(n-vinylcarbazol) (PVK), distyrylarylene (DSA), etc., and dopants such those illustrated in FIGS. 5-7, e.g., PtOEP, Ir(piq)3, Btp2Ir(acac), and DCJTB (which are red-light dopants), Ir(ppy)3 (where "ppy" is phenylpyridine), Ir(ppy)2(acac), and Ir(mpyp)3 (which are green-light dopants), F2Irpic, (F2ppy)2Ir(tmd), Ir(dfppz)3, and ter-fluorene (which are blue-light dopants), etc.

The organic light emitting diode 20 may further include one or more layers between the first electrode 21 and the second electrode 25, e.g., a hole injection layer, a hole transport layer, a hole blocking layer, an electron transport layer, an electron injection layer, etc., in addition to the emissive layer 23. The hole injection layer, the hole transport layer, the hole blocking layer, the electron transport layer and the electron injection layer may be formed of generally known materials using generally known methods. For example, the hole injection layer may be formed of, e.g., a phthalocyanine compound such as copper phthalocyanine described in US Patent No. 4,356,429; a star-burst type amine derivative such as TCTA, m-MTDATA, or m-MTDAPB, etc. The hole transport layer may be formed of, e.g., carbazol derivatives such as N-phenylcarbazol, polyvinylcarbazol, etc., a general amine derivative having an aromatic condensation ring such as 4,4'-bis[N-(1-naphthyl)-N-phenylamino]biphenyl (NPB), N,N'-bis(3-methylphenyl)-N,N'-diphenyl-[1,1-biphenyl]-4,4'-diamine (TPD), N,N'-di(naphthalene-1-yl)-N,N'-diphenyl benzidine (α-NPD), etc. In addition, the hole blocking layer may be formed of, e.g., oxadiazol derivatives, triazol derivatives, phenanthroline derivatives, a hole blocking material as described in Japanese Patent Publication No. 11-329734 A1, Balq, BCP, etc. In addition, the electron transport layer may be formed of, e.g., a quinoline derivative such as tris(8-quinolinorate)aluminum (Alq3), TAZ, or the like. The electron injection layer may be formed of, e.g., LiF, NaCl, CsF, Li20, BaO, etc.

A protection layer (not shown) may be further formed on the OLED 20. The protection layer may include an organic material or an inorganic material that can prevent the second electrode 25 of the OLED 20 from being oxidized by moisture and/or oxygen. In an implementation, the protection layer may have a structure of an organic/inorganic complex layer, etc. The protection layer may be formed between the OLED 20 and the encapsulation layer 30.

As described above, referring to FIG. 1, the encapsulation layer 30 may be formed to cover the OLED 20, and may include the organic layer 31 and the inorganic layer 35. The intermixing region 33 may include the organic material forming the organic layer 31, as well as the inorganic material forming the inorganic layer 35. The intermixing region 33 may be provided at the interface of the organic layer 31 with the inorganic layer 35.

The organic layer 31 may be a polymeric layer. The organic layer 31 may include one or more of an acryl-based resin, a methacryl-based resin, polyisoprene, a vinyl-based resin, an epoxy-based resin, a urethane-based resin, a cellulose-based resin and a perylene-based resin. Examples of the acryl-based resin include butyl acrylate, ethyl hexyl acrylate, etc. Examples of the methacryl-based resin include propyleneglycol methacrylate, tetrahydrofurfuryl methacrylate, etc. Examples of the vinyl-based resin include vinylacetate, N-vinylpyrrolidone, etc. Examples of the epoxy-based resin include cycloaliphatic epoxides, epoxy acrylates, vinyl epoxy-based resins, etc. Examples of the urethane resin include urethane acrylate, etc. Examples of the cellulose-based resin include cellulosenitrate, etc.

The inorganic layer 35 may include one or more of silicon nitride, aluminum nitride, zirconium nitride, titanium nitride, hafnium nitride, tantalum nitride, silicon oxide, aluminum oxide, titanium oxide, tin oxide, cerium oxide, silicon oxide nitride (SiON), etc.

The intermixing region 33 of the organic material forming the organic layer 31 and the inorganic material forming the inorganic layer 35 may be provided at the interface of the organic layer 31 with the inorganic layer 35. The organic layer 31 of the encapsulation layer 30 may provide a planarization function, and the inorganic layer 35 of the encapsulation layer 30 may prevent permeation of moisture and/or oxygen. The intermixing region 33 at the interface of the organic layer 31 with the inorganic layer 35 may provide the planarization function and, at the same time, prevent permeation of moisture and/or oxygen. Further, the intermixing region 33 may smoothly and contiguously transition to the inorganic layer 35. Therefore, the encapsulation layer 30 including the intermixing region 33 may more effectively prevent permeation of oxygen and/or moisture than an encapsulation layer that does not include the intermixing region 33.

In an embodiment, the inorganic layer 35 and the intermixing region 33 may be simultaneously formed. The inorganic layer 35 and the intermixing region 33 may be formed by, e.g., depositing on the organic layer 31 the inorganic material that forms the inorganic layer 35. The deposition may include using ion beam assisted deposition (IBAD). When the inorganic layer 35 and the intermixing region 33 are simultaneously formed, the intermixing region 33 need not be formed using a separate process such as coating, deposition, etc. Rather, the intermixing region 33 may be a layer that is formed during the process of forming the inorganic layer 35, e.g., both layers may be formed using a single IBAD process.

Referring to FIG. 1, the simultaneous formation of the intermixing region 33 and the inorganic layer 35 may produce an interface of the organic layer 31 with the inorganic layer 35 that is not distinct. In particular, the organic material forming the organic layer 31 and the inorganic material forming the inorganic layer 35 may be formed with a concentration gradient at the interface between the organic layer 31 and the intermixing region 33 and/or a concentration gradient at the interface between the intermixing region 33 and the inorganic layer.

As described above, the intermixing region 33 may be formed concomitantly with the inorganic layer 35, e.g., by using an IBAD process to form the intermixing region 33 at the same time as the inorganic layer 35 is formed. Thus, the intermixing region 33 need not be formed using a separate process such as coating, deposition, etc. Accordingly, the encapsulation layer may be formed as an ultra-thin film.

Therefore, the encapsulation layer 30 may prevent permeation of oxygen and/or moisture, while being very thin. For example, the encapsulation layer 30 may have a thickness of about 50 nm to about 5,000 nm, preferably about 100 nm to about 3,000 nm. Therefore, the overall organic light emitting device 10 according to an embodiment may be manufactured to be very thin.

The intermixing region 33 of the encapsulation layer 30 may have a thickness of about 15 nm or less, e.g., about 1 nm to about 15 nm. The intermixing region 33 having a thickness in this range may be inexpensive to manufacture while providing excellent protection against moisture and/or oxygen permeation. Preferably, the intermixing region 33 has a thickness of about 2 nm to about 10 nm.

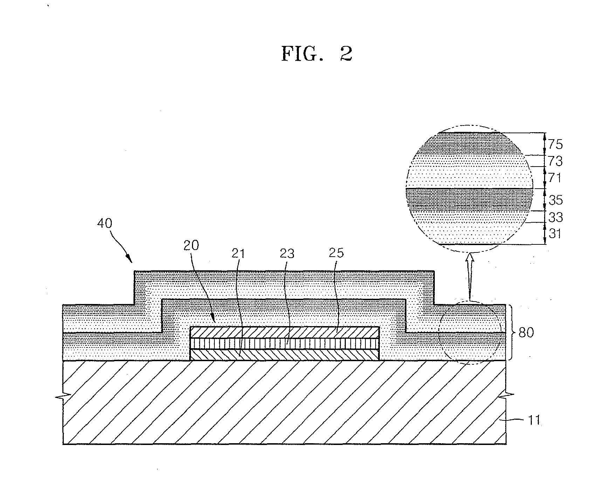

FIG. 2 illustrates an organic light emitting device 40 according to a second embodiment. The organic light emitting device 40 may include the substrate 11, as well as the OLED 20 having the first electrode 21, the emissive layer 23, and the second electrode 25. The organic light emitting device 40 may include an encapsulation layer 80 that covers the OLED 20. In an implementation, the organic light emitting device 40 may further include a protection layer (not shown) on the OLED 20, the protection layer being disposed between the OLED 20 and the encapsulation layer 80. The protection layer may help further prevent oxidation of the second electrode 25 by oxygen and/or moisture.

The encapsulation layer 80 may include the first organic layer 31, the first inorganic layer 35, a second organic layer 71, and a second inorganic layer 75. The first intermixing region 33 may be formed at the interface of the first organic layer 31 and the first inorganic layer 35. A second intermixing region 73 may be formed at the interface of the second organic layer 71 and the second inorganic layer 75. The encapsulation layer 80 may include, in sequence, the OLED 20, the first organic layer 31, the first intermixing region 33, the first inorganic layer 35, the second organic layer 71, the second intermixing region 73, and the second inorganic layer 75. In an implementation, the second organic layer 71 may be directly on the first inorganic layer 35.

The first intermixing region 33 may include the first organic material forming the first organic layer 31 as well as the first inorganic material forming the first inorganic layer 35. The second intermixing region 73 may include a second organic material forming the second organic layer 71 as well as a second inorganic material forming the second inorganic layer 75. The first organic material and the second organic material may be the same or different from each other. Similarly, the first inorganic material and the second inorganic material may be the same or different from each other.

The first organic material and the second organic material may each independently include one or more of an acryl-based resin, a methacryl-based resin, polyisoprene, a vinyl-based resin, an epoxy-based resin, a urethane-based resin, a cellulose-based resin, or a perylene-based resin. The first inorganic material and the second inorganic material may each independently include one or more of silicon nitride, aluminum nitride, zirconium nitride, titanium nitride, hafnium nitride, tantalum nitride, silicon oxide, aluminum oxide, titanium oxide, tin oxide, cerium oxide, or silicon oxide nitride. Examples of these organic and inorganic materials are described above in connection with the first embodiment, and thus will not be repeated.

The first intermixing region 33, which may include the first organic material and the first inorganic material, may be disposed at the interface of the first organic layer 31 with the first inorganic layer 35. In addition, the second intermixing region 73, which may include the second organic material and the second inorganic material, may be disposed at the interface of the second organic layer 71 with the second inorganic layer 75. The first intermixing region 33 and the second intermixing region 73 may each provide a planarization function, while preventing permeation of moisture and/or oxygen. Therefore, the encapsulation layer 80 including the first intermixing region 33 and the second intermixing region 73 may effectively isolate the OLED 20 against oxygen and/or moisture.

The first inorganic layer 35 and the first intermixing region 33 may be simultaneously formed, e.g., by depositing the first inorganic material on the first organic layer 31 using ion beam assisted deposition (IBAD). Similarly, the second inorganic layer 75 and the second intermixing region 73 may be simultaneously formed, e.g., by depositing the second inorganic material on the second organic layer 71 using IBAD. Thus, the first intermixing region 33 and the second intermixing region 73 need not be formed using separate processes such as coating, deposition , etc., but may instead be formed during formation of the respective first and second inorganic layers 35 and 75.

Referring to FIG. 2, the interface of the first organic layer 31 with the first inorganic layer 35, and the interface of the second organic layer 71 with the second inorganic layer 75, may not be distinct. The first organic material forming the first organic layer 31 and the first inorganic material forming the first inorganic layer 35 may exhibit respective, oppositely-trending concentration gradients between the first organic layer 31 and the first inorganic layer 35. In particular, the first organic material forming the first organic layer 31 and the first inorganic material forming the first inorganic layer 35 may be formed with a concentration gradient at the interface between the first organic layer 31 and the first intermixing region 33 and/or a concentration gradient at the interface between the first intermixing region 33 and the first inorganic layer 35. In addition, the second organic material forming the second organic layer 71 and the second inorganic material forming the second inorganic layer 75 may be formed with a concentration gradient at the interface between the second organic layer 71 and the second intermixing region 73 and/or a concentration gradient at the interface between the second intermixing region 73 and the second inorganic layer 75.

The encapsulation layer 80 may be formed as an ultra-thin film, since the first intermixing region 33 and the second intermixing region 73 need not be formed using separate processes such as coating, deposition, etc. Therefore, not only may the encapsulation layer 80 prevent permeation of oxygen and/or moisture, as described above, it may also be formed as an ultra-thin film. The encapsulation layer 80 may have a thickness of about 10 nm to about 10,000 nm, preferably having a thickness of about 60 nm to about 5,500 nm. Accordingly, the organic light emitting device 40 according to the second embodiment may be manufactured to be very thin.

The first intermixing region 33 of the encapsulation layer 80 may have a thickness of about 15 nm or less, e.g., about 1 nm to about 15 nm, and preferably about 2 nm to about 10 nm. The second intermixing region 73 of the encapsulation layer 80 may also have a thickness of about 15 nm or less, e.g., about 1 nm to about 15 nm, and preferably about 2 nm to about 10 nm. Forming the first intermixing region 33 and the second intermixing region 73 with such thicknesses may provide the encapsulation layer 80 with excellent moisture and/or oxygen prevention, while being inexpensive to manufacture.

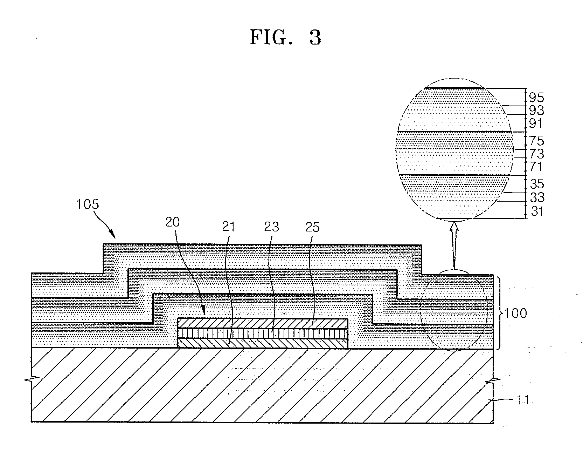

FIG. 3 illustrates a cross-sectional view of an organic light emitting device 105 according to a third embodiment. Referring to FIG. 3, the organic light emitting device may include an encapsulation layer 100 having the first organic layer 31, the first inorganic layer 35, the second organic layer 71, the second inorganic layer 75, a third organic layer 91 and a third inorganic layer 95. The encapsulation layer may further include the first intermixing region 33 between the first organic layer 31 and the first inorganic layer 35, the second intermixing region 73 between the second organic layer 71 and the second inorganic layer 75, and a third intermixing region 93 between the third organic layer 91 and the third inorganic layer 95. The first intermixing region 33, the second intermixing region 73, and the third intermixing region 93 may provide a planarization function, and may prevent permeation of moisture and/or oxygen at the same time. Therefore, the encapsulation layer 100 including the three intermixing regions 33, 73 and 93 may provide excellent characteristics in terms of preventing permeation of oxygen and/or moisture. It will be appreciated that further layers and intermixing regions may be provided, i.e.., an encapsulation layer may include four or more intermixing regions.

The first intermixing region 33 may include the first organic material forming the first organic layer 31, as well as the first inorganic material forming the first inorganic layer 35. The second intermixing region 73 may include the second organic material forming the second organic layer 71, as well as the second inorganic material forming the second inorganic layer 75. The third intermixing region 93 may include a third organic material forming the third organic layer 91, as well as a third inorganic material forming the third inorganic layer 95.

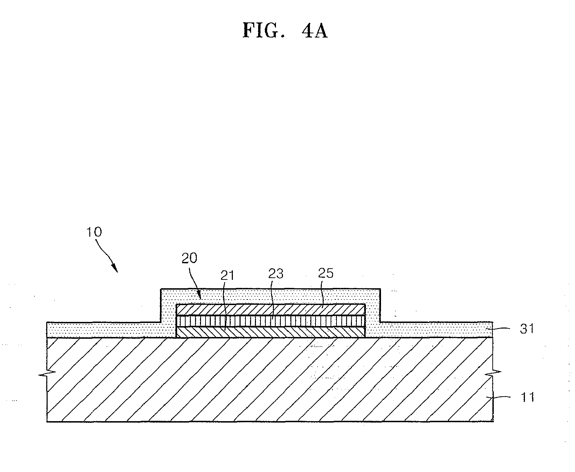

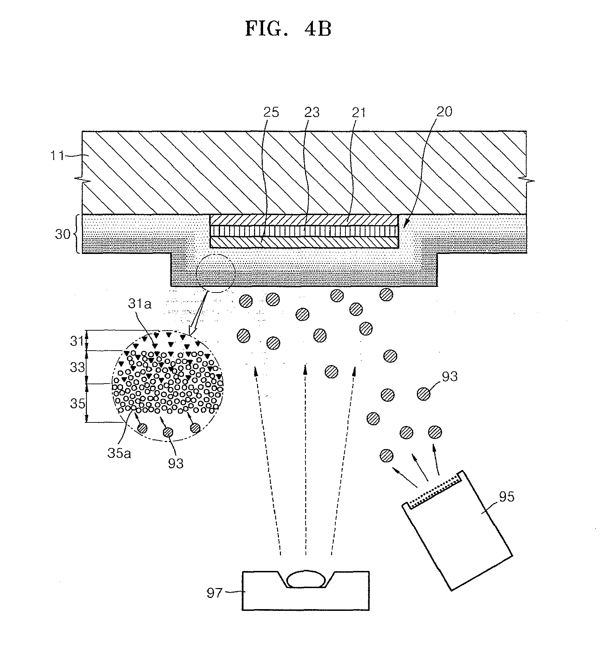

The organic materials used to form the first, second and third organic layers 31, 71, and 91 may be the same or different, and may include the example organic materials described above in connection with the first and second embodiments. The inorganic materials used to form the first, second, and third inorganic layers 35, 75, and 95 may be the same or different, and may include the example inorganic materials described above in connection with the first and second embodiments. Accordingly, details of the organic and inorganic materials will not be repeated. FIGS. 4A and 4B illustrate schematic views of a method of manufacturing the organic light emitting device of FIG. 1. Referring to FIGS. 1, 4A and 4B, the method may include forming one or more OLEDs 20 on the substrate 11, and may further include forming the encapsulation layer 30 to cover the OLEDs 20, as described in detail below.

The substrate 11 may be prepared and the OLEDs 20 may be formed thereon. Each OLED 20 may include the first electrode 21, the emissive layer 23, and the second electrode 25, as described above. One or more of a hole injection layer, a hole transport layer, an electron blocking layer, an electron transport layer, or an electron injection layer may also be formed between the first electrode 21 and the second electrode 23. The OLEDs 20 may be formed using known techniques including, e.g., deposition, sputtering and coating.

Forming the encapsulation layer 30 may include a first operation to apply the organic material that forms the organic layer 31 on the OLEDs 20. The organic layer 31 may be formed to cover the OLEDs 20, as illustrated in FIG. 4A. The organic layer 31 may be formed using suitable film forming methods, e.g., coating, heat treatment, deposition, etc.

After forming the organic layer 31, a second operation that simultaneously forms the intermixing region 33 and the inorganic layer 35 may be performed. The second operation may include applying the inorganic material used for the inorganic layer 35, such that the intermixing region 33 includes the organic material used to form the organic layer 31, as well as an inorganic material used to form the inorganic layer 35. The second operation may be performed by depositing the inorganic material on the organic layer 31 using, e.g., IBAD.

In an implementation, the IBAD process may include depositing an inorganic material 35a on the organic layer 31. The IBAD process may use an evaporation source 97 that supplies the inorganic material 35a, and may also use an ion beam source 95, as illustrated in FIG. 4B. The IBAD process may implant the inorganic material 35a into the previously-formed organic layer 31. For example, mobility of the inorganic material 35a released from the evaporation source 97 may be made higher by ions 93 of an inert atom released from the ion beam source 95. The inorganic material 35a may be embedded into and co-mingled with an organic material 31a that forms the organic layer 31, as shown in the inset in FIG. 4B. Thus, the intermixing region 33 may include the organic material 31a that forms the organic layer 31, as well as the inorganic material 35a that forms the inorganic layer 35. The inorganic material 35a may be continuously deposited following the formation of the intermixing region 33 so as to form the inorganic layer 35 on the intermixing region 33.

Without being bound by theory, it is believed that the above-described operations may substantially reduce or eliminate voids in the inorganic material 35a and avoid defects in the atomic arrangement of the inorganic material 35a. Thus, the inorganic material 35a may be tightly packed in the intermixing region 33 and at the interface thereof with the inorganic layer 35, as well as throughout the inorganic layer 35, which may enhance the ability of the encapsulation layer 30 as a whole to prevent permeation of moisture and/or oxygen.

The ions 93 released from the ion beam source 95 used in the IBAD process may not react with the organic material 31a forming the organic layer 31 and/or the inorganic material 35a that is released from the evaporation source 97. The ions 93 may include ions of an inert gas, etc., and may include e.g., Ar+, Kr+, Xe+, etc. The ion beam source 95 used in the IBAD process may have an energy of about 50 eV to about 200 eV, preferably about 80 eV to about 150 eV. When the energy of the ion beam source 95 is about 50 eV or more, the ions 93 released from the ion beam source 95 may be highly effective to increase surface mobility of the inorganic material 35a. When the energy of the ion beam source 95 is about 200 eV or less, the intermixing region 33 and the inorganic layer 35 may be effectively formed, with little or no etching of the organic layer 31.

In the IBAD process, a ratio of the number of particles of the inorganic material 35a released from the evaporation source 97 to the number of the ions 93 released from the ion beam source 95 may be about 1:1 to about 0.9:1, and is preferably about 0.9:1. When the ratio of the number of particles of the inorganic material 35a to the number of the ions 93 is about 1:1 to about 0.9:1, the intermixing region 33 and the inorganic layer 35 may be effectively formed, with little or no etching of the organic layer 31.

The ratio of the number of particles of the inorganic material 35a to the number of the ions 93 may be generally controlled by adjusting ion flow or flow of ion generating gas of the ion beam source 95. For example, where the inorganic material 35a is Si02, it may be deposited using the evaporation source 97 releasing Si02 particles and the ion beam source 95 releasing argon ions 93. In an implementation, the ion flow of the ion beam source 95 may be adjusted to about 50 mA and the flow of argon gas may be adjusted to about 5 seem to produce a ratio of the number of Si02 particles to the number of the argon ions that is about 1:1.

In the process of forming an inorganic layer 35 and an intermixing layer 33 using IBAD, either a thermal evaporation source or an electron evaporation source may be used as the evaporation source 97. In addition, a Kaufmann type ion gun, an Endhall type ion gun, an RF type ion gun, etc., may be used, the particular choice of which may be based on the available equipment, the material(s) being deposited, the nature of the organic layer 31 undergoing implantation, etc.

The operations described above in connection with FIGS. 1, 4A, and 4B may be extended to form the organic light emitting device 40 illustrated in FIG. 2. For example, a third operation may be performed to form the second organic layer 71 on the first inorganic layer 34. Subsequently, a fourth operation may be performed that simultaneously forms the second intermixing region 73 and the second inorganic layer 75. The fourth operation may be performed by depositing the second inorganic material on the second organic layer, e.g., using IBAD.

The second organic layer 71 may include the second organic material, and the second inorganic layer 75 may include the second inorganic material. The second intermixing region 73 may include the second organic material and the second inorganic material. The first organic material, the second organic material, the first inorganic material, the second inorganic material, and the IBAD process may be the same as those described above in connection with FIGS. 1 and 2, and therefore will not be repeated.

The operations described above in connection with FIGS. 1, 2, 4A, and 4B may be further extended to form the organic light emitting device 105 illustrated in FIG. 3. For example, after the first, second, third, and fourth operations described above, forming the 100 encapsulation layer may further include a fifth operation that forms the third organic layer 91 on the second inorganic layer 75. Subsequently, a sixth operation may be performed that simultaneously forms the third inorganic layer 95 and the third intermixing region 93. The third intermixing region 93 may include the third organic material forming the third organic layer 91 and the third inorganic material forming the third inorganic layer 95. The third inorganic material may be embedded in and deposited on the third organic layer 91, e.g., using IBAD. The third organic material, the third inorganic material, and the IBAD process may be the same as those described above in connection with FIG. 3, and therefore will not be repeated.

The following Example is provided in order to set forth particular details of one or more embodiments. However, it will be understood that the embodiments are not limited to the particular details described.

### Example

A glass substrate was prepared having an OLED thereon. An acryl-based monomer (obtained from Vitex Systems, Inc (San Jose, California, USA)) was then coated to cover the OLED and UV-cured to form an acryl resin organic layer having a thickness of 1,500 nm. Si02 was deposited on the organic layer using IBAD to form an intermixing region including Si02 and the acryl resin of the organic layer, and simultaneously form an inorganic layer of Si02.

In detail, a chamber including a Si02 deposition source, an ion beam source, a thermal evaporation source, a substrate holder and a rotating shaft that rotates a substrate holder was prepared. An Endhall type ion gun (obtained from Infovion, Inc. (Korea)) was used as the ion beam source, and a Helisys (obtained from ANS, Inc. (Korea)) was used as the thermal evaporation source. The substrate on which the OLED and the organic layer were formed was mounted on the substrate holder and positioned to face the Si02 deposition source. Then, the chamber was operated under the conditions shown in Table 1 (below) to simultaneously form the inorganic layer of Si02 and the intermixing region in which Si02 was implanted in the acryl resin of the organic layer, with the intermixing region being formed between the acryl resin organic layer and the layer of Si02. Argon was used as in inert gas to form the ion beam.

**Table 1:**

| | |
|---|---|
| Base pressure | 1.0 x 10-7 Torr |
| Gas flow | Oxygen flow: 2 sccm Argon flow: 5 seem |
| Thermal evaporation source | Tungsten boat, BN boat |
| Operation condition of thermal evaporation source (amperes) | 200 A |
| Ion beam source | Endhall type ion gun |
| Operation condition of ion beam | Discharge current: 500 mA |
| source | Discharge voltage: 300 V |
| | Beam voltage: 150e V |
| | Beam current: 50 mA |
| Deposition angle | 90° |
| Substrate RPM | 4.5 |
| Substrate temperature | 80 °C |
| Deposition velocity | 5 Å/sec |

The resulting organic light emitting device included an encapsulation layer covering the OLED, the encapsulation layer having an acryl resin organic layer, a Si02 inorganic layer, and an intermixing region of the acryl resin and Si02 formed between the organic layer and the inorganic layer. The encapsulation layer had a thickness of about 1,600 nm.

As described above, an encapsulation layer according to embodiments may include an organic layer and an inorganic layer. An intermixing region of an organic material forming the organic layer and an inorganic material forming the inorganic layer may be formed between the organic layer and the inorganic layer. The encapsulation layer may be an ultra-thin film, and may effectively prevent permeation of oxygen and/or moisture. An organic light emitting device including the encapsulation layer according to embodiments may have a long lifetime and high luminance. In addition, a method of manufacturing an organic light emitting device according to embodiments may provide a simple manufacturing process, which may allow manufacturing costs to be reduced.

Exemplary embodiments have been disclosed herein, and although specific terms are employed, they are used and are to be interpreted in a generic and descriptive sense only and not for purpose of limitation. Accordingly, it will be understood by those of ordinary skill in the art that various changes in form and details may be made without departing from the scope of the present invention as set forth in the following claims.

## Claims

1. An organic light emitting device, comprising:
an organic light emitting diode on a substrate; and
an encapsulation layer covering the organic light emitting diode, wherein:
the encapsulation layer includes an organic layer, an inorganic layer on the organic layer, and an intermixing region between the organic layer and the inorganic layer,
the organic layer includes an organic material,
the inorganic layer includes an inorganic material, and
the intermixing region includes the organic material and the inorganic material.

2. The organic light emitting device as claimed in claim 1, wherein the organic layer is a polymeric layer.

3. The organic light emitting device as claimed in claim 1 or 2, wherein the inorganic material includes one or more of silicon nitride, aluminum nitride, zirconium nitride, titanium nitride, hafnium nitride, tantalum nitride, silicon oxide, aluminum oxide, titanium oxide, tin oxide, cerium oxide, or silicon oxide nitride.

4. The organic light emitting device as claimed in any one of the preceding claims, wherein the inorganic material exhibits a concentration gradient at an interface with the intermixing region.

5. The organic light emitting device as claimed in any one of the preceding claims, wherein:
the organic material exhibits a concentration gradient at an interface with the intermixing region.

6. The organic light emitting device as claimed in any one of the preceding claims, wherein the intermixing region has a thickness of about 1 nm to about 15 nm.

7. The organic light emitting device as claimed in claim 1, wherein:
the encapsulation layer includes the organic layer, the inorganic layer, and the intermixing region in a stack with a second organic layer, a second inorganic layer, and a second intermixing region, the second intermixing region being between the second organic layer and the second inorganic layer,
the second organic layer is on the inorganic layer,
the intermixing region has a thickness of about 1 nm to about 15 nm, and
the second intermixing region has a thickness of about 1 nm to about 15 nm.

8. A method of manufacturing an organic light emitting device, comprising:
providing a substrate having an organic light emitting diode thereon; and
forming an encapsulation layer covering the organic light emitting diode, wherein forming the encapsulation layer includes:
forming an organic layer; and
using ion beam assisted deposition to simultaneously form an inorganic layer and an intermixing region, the intermixing region being between the organic layer and the inorganic layer, wherein:
the organic layer includes an organic material,
the inorganic layer includes an inorganic material, and
the intermixing region includes the organic material and the inorganic material.

9. The method as claimed in claim 8, wherein the ion beam assisted deposition forms the intermixing region by implanting particles of the inorganic material to a predetermined depth in the organic layer.

10. The method as claimed in claim 9, where the predetermined depth is about 1 nm to about 15 nm.

11. The method as claimed in claim 8, 9 or 10, wherein the inorganic material is deposited with a concentration gradient at an interface with the intermixing region.

12. The method as claimed in any one of claims 8 to 11, wherein the organic material is deposited with a concentration gradient at an interface with the intermixing region.

13. The method as claimed in any one of claims 8 to 12, wherein:
the ion beam assisted deposition is performed with an ion beam source that releases ions of an inert atom, and
the ion beam source has an energy of about 50 eV to about 200 eV.

14. The method as claimed in any one of claims 8 to 13, wherein forming the encapsulation layer further includes:
forming a second organic layer on the inorganic layer; and
using ion beam assisted deposition to simultaneously form a second inorganic layer and a second intermixing region, the second intermixing region being between the second organic layer and the second inorganic layer, wherein:
the intermixing region has a thickness of about 1 nm to about 15 nm, and
the second intermixing region has a thickness of about 1 nm to about 15 nm.

15. A method of encapsulating a device, comprising:
providing a substrate having the device thereon;
applying a first layer to cover the device; and
after applying the first layer, implanting an inorganic material to a predetermined depth into an exposed surface of the first layer.
